# EUROPÄISCHE PATENTANMELDUNG

(11) **EP 2 276 331 A1**
(43) Veröffentlichungstag der Anmeldung: **19.01.2011**
(21) Anmeldenummer: 09009109.1
(22) Anmeldetag: 13.07.2009
(51) Int. Cl.: H05K 7/08, H05K 1/00, H05K 3/22

(54) **Kabelsatz und Verfahren zur Herstellung eines Kabelsatzes**

(71) Anmelder: Delphi Technologies, Inc., Troy MI 48007 (US)
(72) Erfinder: Larisch, Markus, 46284 Dorsten (DE)
(74) Vertreter: Manitz, Finsterwald & Partner GbR

(57) **Zusammenfassung**

Ein Kabelsatz, insbesondere für ein elektrisches Verteilungssystem für ein Kraftfahrzeug, umfasst eine Platine mit parallel zueinander in einer Richtung auf der Platine verlaufenden Leiterbahnen und wenigstens zwei Steckverbinder. Jeder der wenigstens zwei Steckverbinder weist zumindest eine Reihe von Kontaktkammern auf. Jede Kontaktkammer ist zur Aufnahme von jeweils einem insbesondere buchsenartig oder stiftartig ausgebildeten Kontaktelement ausgebildet. Die wenigstens zwei Steckverbinder sind derart an der Platine angebracht oder anbringbar, dass die Reihen von Kontaktkammern der wenigstens zwei Steckverbinder quer zur Verlaufsrichtung der Leiterbahnen angeordnet sind.

## Beschreibung

Die Erfindung betrifft einen Kabelsatz, insbesondere für ein elektrisches Verteilungssystem für ein Kraftfahrzeug, und ein Verfahren zur Herstellung eines derartigen Kabelsatzes.

Bekannte Kabelsätze für elektrische Verteilungssysteme für ein Kraftfahrzeug umfassen eine Platine, die auch als Leiterplatte bezeichnet wird, und mehrere Steckverbinder mit jeweils daran angeordneten Leitungssätzen. Die Steckverbinder weisen jeweils eine oder mehrere Reihen von Kontaktkammern auf. In den einzelnen Kontaktkammern kann jeweils ein Kontaktelement angeordnet sein, welches mit jeweils einer elektrischen Einzelleitung des an dem Steckverbinder angeordneten Leitungssatzes elektrisch verbunden ist. Jedes in einer Kontaktkammer angeordnete Kontaktelement dient zur elektrischen Kontaktierung einer Leiterbahn der Platine.

Bei bekannten Kabelsätzen lassen sich die Steckverbinder derart an der Platine befestigen, dass die an den Steckverbindern angeordneten Leitungssätze über die Leiterbahnen der Platine in einer gewünschten Art und Weise miteinander elektrisch verbunden werden. Insbesondere ist bei derartigen Kabelsätzen das Layout der Platine derart ausgebildet, dass jeweils miteinander zu verbindende Einzelleitungen verschiedener Leitungssätze über einzelne Leiterbahnen der Platine miteinander elektrisch verbunden werden. Daher ist das Layout der Platine bei bekannten Kabelsätzen an die jeweiligen, an die Platine anzuschließenden Leitungssätze angepasst.

Der Erfindung liegt die Aufgabe zugrunde, einen Kabelsatz anzugeben, bei dem die Platine ein einfacheres Layout aufweist und bei dem insbesondere keine Anpassung des Platinenlayouts an die jeweiligen Leitungssätze des Kabelsatzes erforderlich ist.

Diese Aufgabe wird durch einen Kabelsatz mit den Merkmalen des Anspruchs 1 gelöst. Erfindungsgemäß umfasst der Kabelsatz eine Platine mit parallel zueinander in einer Richtung auf der Platine verlaufenden Leiterbahnen und wenigstens zwei Steckverbinder. Jeder der wenigstens zwei Steckverbinder weist zumindest eine Reihe von Kontaktkammern auf. Jede Kontaktkammer ist zur Aufnahme von jeweils einem insbesondere buchsenartig oder stiftartig ausgebildeten Kontaktelement ausgebildet. Die Steckverbinder sind derart an der Platine angebracht oder anbringbar, dass die Reihen von Kontaktkammern der beiden Steckverbinder quer zur Verlaufsrichtung der Leiterbahnen angeordnet sind.

Bei dem erfindungsgemäßen Kabelsatz wird daher keine Platine mit einer speziell für den Kabelsatz ausgebildeten Leiterbahnstruktur benötigt. Vielmehr weist die Platine bei dem erfindungsgemäßen Kabelsatz aufgrund der parallel zueinander verlaufenden Leiterbahnen ein einfaches, einfach herzustellendes Standardlayout auf. Dadurch entfallen die Herstellungskosten für eine speziell für den Kabelsatz ausgebildete Platine, was auch eine Reduktion der Herstellungskosten für den Kabelsatz insgesamt zur Folge hat.

Durch den erfindungsgemäßen Kabelsatz lässt sich ferner die Verschaltung der Steckverbinder untereinander vereinfachen und schneller durchführen, weil diese lediglich jeweils mit quer zur Verlaufsrichtung der Leiterbahnen ausgerichteter Reihe von Kontaktkammern an der Platine befestigbar sind. Dabei werden die Kontaktelemente unterschiedlicher Steckverbinder, die dieselbe Leiterbahn kontaktieren, elektrisch kurzgeschlossen und somit über die jeweilige Leiterbahn elektrisch miteinander verbunden.

Weiterbildungen und bevorzugte Ausführungsformen der Erfindung sind in den abhängigen Ansprüchen, der Beschreibung und der Zeichnung angegeben.

Bevorzugt sind die wenigstens zwei Steckverbinder derart an der Platine angebracht oder anbringbar, dass die Steckverbinder nebeneinander und mit parallel zueinander angeordneten Reihen von Kontaktkammern an der Platine angeordnet sind. Dadurch lässt sich der auf der Platine zur Verfügung stehende Platz zur Anordnung der Steckverbinder optimal nutzen, so dass der Kabelsatz kompakt gehalten werden kann. Dies hat auch den Vorteil, dass beispielsweise in einem Kraftfahrzeug zur Unterbringung des erfindungsgemäßen Kabelsatzes nur ein geringer Bauraum vorgesehen werden muss.

Nach einer Ausgestaltung der Erfindung ist die Reihe von Kontaktkammern jedes Steckverbinders derart ausgebildet, dass benachbarte Leiterbahnen der Platine von in benachbarten Kontaktkammern gegebenenfalls angeordneten Kontaktelementen elektrisch kontaktierbar sind. Demnach ist die Reihe von Kontaktkammern eines jeden Steckverbinders für die Anbringung an der Platine konfektioniert. Dabei sind mit benachbarten Leiterbahnen nebeneinander angeordnete Leiterbahnen gemeint, zwischen denen keine weitere Leiterbahn mehr angeordnet ist. Entsprechend werden direkt nebeneinander angeordnete Kontaktkammern einer Reihe von Kontaktkammern als benachbarte Kontaktkammern bezeichnet.

Bevorzugt ist an jedem Steckverbinder ein Leitungssatz mit einer oder mehreren elektrischen Einzelleitungen angeordnet. Über die Einzelleitungen können jeweils elektrische Signale oder dergleichen der Platine zugeführt und/oder von der Platine abgegriffen werden. Vorzugsweise ist dabei jeweils eine elektrische Einzelleitung mit einem Kontaktelement des jeweiligen Steckverbinders elektrisch verbunden, so dass die jeweilige Einzelleitung über das entsprechende Kontaktelement mit einer Leiterbahn der Platine elektrisch verbindbar ist.

Wie zuvor erwähnt, kann eine elektrische Einzelleitung eines Leitungssatzes zur Zuführung und/oder zur Wegleitung eines elektrischen Signals oder dergleichen vorgesehen sein. Mit jedem Leitungssatz können daher elektrische Signale der Platine zugeführt und/oder von der Platine weggeführt werden, so dass die elektrischen Signale mittels der Platine zwischen den einzelnen Leitungssätzen verteilt werden können. Die elektrischen Signale umfassen dabei nicht nur die beispielsweise in Kraftfahrzeugen typischerweise verwendeten Daten- und Steuersignale, sondern auch Versorgungsspannungen und die elektrische Masse.

Insbesondere kann jeder Leiterbahn der Platine ein elektrisches Signal zugeordnet sein, welches der Leiterbahn zugeführt und/oder von dieser abgegriffen werden soll. Ein Kontaktelement eines Steckverbinders, welches zur Zuführung und/oder zum Abgreifen von einem bestimmten der zugeordneten Signale vorgesehen ist und insbesondere mit der entsprechenden Einzelleitung des an dem Steckverbinder angeordneten Leitungssatzes verbunden ist, kann dabei derart in der Reihe von Kontaktkammern des Steckverbinders angeordnet sein, dass die Leiterbahn, welcher das bestimmte Signal zugeordnet ist, bei Anbringung des Steckverbinders an der Platine von dem jeweiligen Kontaktelement des Steckverbinders elektrisch kontaktiert wird.

Durch geeignete Belegung der einzelnen Kontaktkammern der Steckverbinder können insbesondere auch wegen der parallel verlaufenden Leiterbahnen empfindliche Datenleitungen von störbehafteten Hochstromleitungen durch dazwischen liegende Masseleitungen auf der Platine getrennt werden. Ferner kann der Wellenwiderstand der Leiterbahnen auf der Platine in einfacher Weise optimiert werden, indem beispielsweise der Abstand der parallel verlaufenden Leiterbahnen in geeigneter Weise gewählt wird. Daher eignet sich der erfindungsgemäße Kabelsatz auch besonders gut zur Leitung von insbesondere störanfälligen Datensignalen.

Vorzugsweise werden keine Kontaktelemente in Kontaktkammern der Reihe von Kontaktkammern des jeweiligen Steckverbinders angeordnet, welche nicht zur Aufnahme eines Kontaktelements zur Zuführung und/oder zum Abgreifen von einem der zugeordneten Signale vorgesehen sind. Daher können einzelne Kontaktkammern eines Steckverbinders auch kein Kontaktelement aufweisen.

Nach einer weiteren Ausgestaltung der Erfindung sind an den Leiterbahnen der Platine Gegenkontakte angeordnet. Diese verlaufen auf der Platine in mehreren Reihen quer zur Verlaufsrichtung der Leiterbahnen. Bevorzugt ist jeweils ein Steckverbinder einer bestimmten Reihe von Gegenkontakten zugeordnet. Insbesondere kann die Reihe von Gegenkontakten so ausgebildet sein, dass diese nur auf denjenigen Leiterbahnen Gegenkontakte aufweist, welche von dem zugeordneten Steckverbinder kontaktiert werden können. Insofern können auch in der Reihe von Gegenkontakten einzelne Gegenkontakte frei bleiben. Die Positionen der frei bleibenden Gegenkontakte entsprechen dabei den Positionen der frei bleibenden Kontaktkammern des zugeordneten Steckverbinders. Daher korrespondiert die Belegung der Reihe von Gegenkontakten mit einzelnen Gegenkontakten mit der Belegung der Reihe von Kontaktkammern des Steckverbinders mit einzelnen Kontaktelementen.

Daher können die Kontaktkammern eines Steckverbinders, die keine Kontaktelemente aufweisen, eine eindeutige Kodierung des Steckverbinders definieren. Diese Kodierung kann zur Anbringung des Steckverbinders an der Platine verwendet werden, da die dem Steckverbinder zugeordnete Reihe von Gegenkontakten entsprechend den im vorhergehenden Absatz gemachten Ausführungen in einfacher Weise identifiziert werden kann.

Vorzugsweise kann jeder Steckverbinder aus einem Einheits-Steckverbinder mit einer relativ langen Reihe von Kontaktkammern durch geeignete Ablängung des Einheits-Steckverbinders auf die jeweils notwendige Anzahl von Kontaktkammern hergestellt werden.

Ferner können die Leiterbahnen der Platine in Querrichtung zu ihrer Verlaufsrichtung dieselbe Breite aufweisen und gleichmäßig, insbesondere in einem vorgegebenen Abstand, voneinander beabstandet sein. Ein derartiges Layout lässt besonders einfach und kostengünstig herstellen.

Bevorzugt erstrecken sich die Leiterbahnen geradlinig in der Verlaufsrichtung. Die Leiterbahnen bestehen in diesem Fall aus parallel zueinander verlaufenden Streifen. Vorzugsweise haben alle Leiterbahnen in Verlaufsrichtung dieselbe Länge. Die Leiterbahnen können jeweils aus einer leitenden, insbesondere metallischen Schicht ausgebildet sind. Alternativ kann jede Leiterbahn aus einem Metallkamm ausgebildet sein.

Vorzugsweise ist eine elektrisch leitende Brücke zwischen zwei benachbarten Leiterbahnen an der Platine befestigt, um die zwei benachbarten Leiterbahnen elektrisch zu verbinden. Mittels der Brücke lassen sich daher in einfacher und flexibler Weise benachbarte Leiterbahnen elektrisch kurzschließen.

Eine Leiterbahn der Platine kann vorzugsweise mittels eines mechanischen Bearbeitungsprozesses, insbesondere eines Schneid-, Bohr- und/oder Fräsprozesses, in wenigstens zwei Leiterbahnabschnitte unterteilt sein, die elektrisch voneinander isoliert sind.

Die Erfindung betrifft ferner ein Verfahren zur Herstellung eines Kabelsatzes. Erfindungsgemäß werden die wenigstens zwei Steckverbinder derart an der Platine befestigt, dass die Reihen von Kontaktkammern der wenigstens zwei Steckverbinder quer zur Verlaufsrichtung der Leiterbahnen und insbesondere parallel zueinander angeordnet sind.

Bevorzugt wird jeder Leiterbahn der Platine ein elektrisches Signal zugeordnet. Ein Kontaktelement eines Steckverbinders, welches zur Zuführung und/oder zum Abgreifen von einem bestimmten der zugeordneten Signale vorgesehen ist, wird derart in der Reihe von Kontaktkammern des Steckverbinders angeordnet, dass die Leiterbahn, welcher das bestimmte Signal zugeordnet ist, bei Anbringung des Steckverbinders an der Platine von dem Kontaktelement elektrisch kontaktiert wird.

Vorzugsweise werden keine Kontaktelemente in Kontaktkammern der Reihe von Kontaktkammern des jeweiligen Steckverbinders angeordnet, welche nicht zur Aufnahme eines Kontaktelements zur Zuführung und/oder zum Abgreifen von einem der zugeordneten Signale vorgesehen sind.

Durch den erfindungsgemäßen Kabelsatz beziehungsweise das erfindungsgemäße Verfahren zur Herstellung des Kabelsatzes kann ein so genannter kundenspezifischer Kabelsatz (KSK) in einfacher Weise realisiert werden. Dabei wird mit dem Begriff kundenspezifischer Kabelsatz auf einen Kabelsatz abgestellt, der kundenspezifisch für ein einziges Fahrzeug gefertigt wird. Insbesondere erfolgt beim kundenspezifischen Kabelsatz die elektrische Verschaltung der Leitungen entsprechend den Ausstattungswünschen des Fahrzeugkäufers, so dass sich keine nicht benötigte elektrische Leitung im fertigen Fahrzeug befindet. Dabei benötigt jedes Fahrzeug aufgrund der unterschiedlichen Ausstattung einen eigenen, dem Kraftfahrzeug angepassten Kabelsatz, welcher durch das erfindungsgemäße Verfahren in einfacher Weise realisiert werden kann.

Nicht beschränkende Ausführungsbeispiele der Erfindung sind in der Zeichnung dargestellt und werden nachfolgend beschrieben.

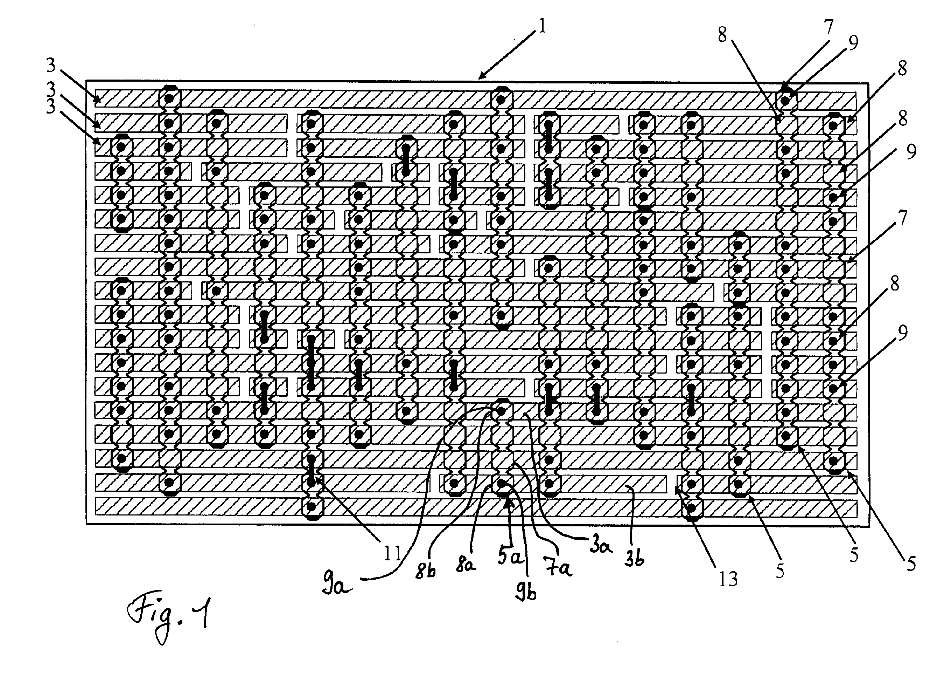

- Fig. 1: zeigt in schematischer Darstellung eine Draufsicht auf eine Platine mit daran befestigten Steckverbindern ei- nes erfindungsgemäßen Kabelsatzes.

Die Platine 1 weist Leiterbahnen 3 auf, welche parallel zueinander in einer Richtung auf der Platine 1 verlaufen. Mehrere Steckverbinder 5 sind an der Platine 1 angebracht. Alle Steckverbinder 5 weisen eine Reihe von Kontaktkammern 7 auf. Jede Kontaktkammer 8 der Reihe von Kontaktkammern 7 ist zur Aufnahme von einem nicht gezeigten buchsenartig ausgebildeten Kontaktelement ausgebildet. Alle Steckverbinder 5 lassen sich mit quer zur Verlaufsrichtung der Leiterbahnen 3 ausgerichteter Reihe von Kontaktkammern 7 an der Platine 1 befestigen.

Insbesondere können alle Steckverbinder 5 nebeneinander und mit parallel zueinander angeordneten Reihen von Kontaktkammern 7 an der Platine 1 angebracht werden. Dadurch lassen sich die Steckverbinder 5 in kompakter Weise an der Platine 1 anbringen, so dass beispielsweise in einem Kraftfahrzeug zur Unterbringung der Platine 1 mit den daran angeordneten Steckverbindern 5 nur ein geringer Platz benötigt wird.

Jeder Steckverbinder 5 ist passend für die Platine 1 konfektioniert. Daher lässt sich jeder Steckverbinder 5 so an der Platine 1 anbringen, dass benachbarte Leiterbahnen 3 der Platine 1 von in benachbarten Kontaktkammern 8 angeordneten Kontaktelementen elektrisch kontaktiert werden.

Insbesondere sind Gegenkontakte 9, bei denen es sich vorzugsweise um Kontaktstifte handelt, an den Leiterbahnen 3 der Platine 1 angeordnet. Die Gegenkontakte 9 verlaufen in mehreren parallelen, quer zur Verlaufsrichtung der Leiterbahnen 3 angeordneten Reihen, welche bevorzugt derart zueinander benachbart sind, dass benachbarte Steckverbinder 5 an benachbarte Reihen von Gegenkontakten 9 angeschlossen werden können.

Jeder Steckverbinder 5 ist vorzugsweise einer bestimmten Reihe von Gegenkontakten zugeordnet. Dabei entspricht die Belegung der Reihe von Gegenkontakten mit Gegenkontakten der Belegung der Reihe von Kontaktkammern mit Kontaktelementen. Beispielsweise weist der Steckverbinder 5a eine Reihe von Kontaktkammern 7a auf. In der Reihe von Kontaktkammern 7a sind die außenliegenden Kontaktkammern 8a, 8b mit Kontaktelementen belegt. Mittels der Kontaktelemente sollen die Leiterbahnen 3a und 3b kontaktiert werden. Insofern weist die, dem Steckverbinder 5a zugeordnete Reihe von Gegenkontakten, auf die der Steckverbinder 5a in Fig. 1 gesteckt ist, lediglich auf der Leiterbahn 3a und der Leiterbahn 3b Gegenkontakte 9a, 9b auf. Daher lässt sich die dem Steckverbinder 5a zugeordnete Reihe von Gegenkontakten in einfacher Weise auf der Platine 1 identifizieren, weil die Anordnung der Gegenkontakte 9a, 9b in der Reihe von Gegenkontakten, wie gesagt, der Anordnung der Kontaktelemente in der Reihe von Kontaktkammern 7a des Steckverbinders 5a entspricht. Insofern weist der Steckverbinder 5a aufgrund der Belegung der Reihe von Kontaktkammern 7a mit Kontaktelementen eine Kodierung auf, mittels der die zugeordnete Reihe von Gegenkontakten 9a, 9b auf der Platine relativ einfach auffindbar ist.

An jedem Steckverbinder 5 kann ein nicht dargestellter Leitungssatz mit einer oder mehreren elektrischen Einzelleitungen angeordnet sein. Insbesondere ist jeweils eine elektrische Einzelleitung eines Leitungssatzes mit jeweils einem Kontaktelement des Steckverbinders 5, an dem der Leitungssatz angeordnet ist, elektrisch verbunden.

Eine elektrische Einzelleitung eines Leitungssatzes wird zur Zuführung und/oder zur Wegleitung eines elektrischen Signals oder dergleichen verwendet. Die elektrischen Signale, insbesondere Daten- und Steuersignale, aber auch Masse und Versorgungsspannungen, können daher mittels eines Steckverbinders 5 auf jeweils eine Leiterbahn 3 der Platine 1 geleitet werden, so dass diese von anderen Steckverbindern 5 abgegriffen werden können. Die elektrischen Signale lassen sich daher mittels der Platine 1 zwischen den einzelnen Steckverbindern 5 und damit zwischen den daran angeordneten Leitungssätzen verteilen.

Insbesondere kann jeder Leiterbahn 3 der Platine 1 ein elektrisches Signal zugeordnet sein. Dabei ist ein Kontaktelement eines Steckverbinders 5, welches zur Zuführung und/oder zum Abgreifen von einem bestimmten der zugeordneten Signale vorgesehen ist und insbesondere mit der entsprechenden Einzelleitung des an dem Steckverbinder 5 angeordneten Leitungssatzes verbunden ist, derart in der Reihe von Kontaktkammern 7 des jeweiligen Steckverbinders 5 angeordnet, dass die Leiterbahn 3, welcher das bestimmte Signal zugeordnet ist, bei Anbringung des jeweiligen Steckverbinders 5 an der Platine 1 von dem jeweiligen Kontaktelement des Steckverbinders 5 elektrisch kontaktiert wird.

Bei geeigneter Auswahl der Leiterbahnen 3 zur Führung der verschiedenen elektrischen Signale können gegenseitige elektrische Einflüsse der Signale reduziert werden. So können beispielsweise empfindliche Datenleitungen von störbehafteten Hochstromleitungen durch dazwischen liegende Leiterbahnen zur Masseleitung getrennt werden. Aufgrund der parallel verlaufenden Leiterbahnen kann auch der Wellenwiderstand der Leiterbahnen zur Übertragung von Datensignalen in besonders einfacher Weise optimiert werden, zum Beispiel durch Anpassung des Abstands benachbarter Leiterbahnen.

An der Platine können auch Brücken 11 angeordnet sein, mit denen jeweils zwei benachbarte Leiterbahnen 3 elektrisch kurzgeschlossen werden. Darüber hinaus kann eine Leiterbahn 3 an einer mechanisch in die jeweilige Leiterbahn 3 eingebrachten Durchtrennungsstelle 13 in zwei Leiterbahnabschnitte unterteilt sein, die voneinander elektrisch isoliert sind. Durch Brücken und Durchtrennungsstellen wird eine gewisse Flexibilität im Hinblick auf das Layout der Platine 1 sichergestellt. Insbesondere lässt sich das einfache, streifenförmige Layout der Platine 1 durch Brücken und Durchtrennungsstellen in einfacher Weise ändern und so gegebenenfalls an eine beispielsweise geänderte Anordnung der Kontaktelemente in einer Reihe von Kontaktkammern 7 eines Steckverbinders 5 anpassen.

### Bezugszeichenliste

- 1: Platine
- 3, 3a, 3b: Leiterbahn
- 5, 5a: Steckverbinder
- 7, 7a: Reihe von Kontaktkammern
- 8, 8a, 8b: Kontaktkammer
- 9, 9a, 9b: Gegenkontakte
- 11: Brücke
- 13: Durchtrennungsstelle

## Patentansprüche

1. Kabelsatz, insbesondere für ein elektrisches Verteilungssystem für ein Kraftfahrzeug, umfassend:
eine Platine (1) mit parallel zueinander in einer Richtung auf der Platine (1) verlaufenden Leiterbahnen (3), und
wenigstens zwei Steckverbinder (5), wobei jeder der wenigstens zwei Steckverbinder zumindest eine Reihe von Kontaktkammern (7) aufweist und jede Kontaktkammer (8) zur Aufnahme von jeweils einem insbesondere buchsenartig oder stiftartig ausgebildeten Kontaktelement ausgebildet ist, und wobei die wenigstens zwei Steckverbinder (5) derart an der Platine (1) angebracht oder anbringbar sind,
dass die Reihen von Kontaktkammern (7) der wenigstens zwei Steckverbinder (5) quer zur Verlaufsrichtung der Leiterbahnen (3) angeordnet sind.

2. Kabelsatz nach Anspruch 1,
**dadurch gekennzeichnet, dass**
die wenigstens zwei Steckverbinder (5) derart an der Platine (1) angebracht oder anbringbar sind, dass die Steckverbinder (5) nebeneinander und mit parallel zueinander angeordneten Reihen von Kontaktkammern (7) an der Platine (1) angeordnet sind.

3. Kabelsatz nach Anspruch 1 oder 2,
durch **gekennzeichnet**, dass
die Reihe von Kontaktkammern (7) jedes Steckverbinders (5) derart ausgebildet ist, dass benachbarte Leiterbahnen (3) der Platine (1) von in benachbarten Kontaktkammern (8) gegebenenfalls angeordneten Kontaktelementen elektrisch kontaktierbar sind.

4. Kabelsatz nach zumindest einem der vorstehenden Ansprüche, **dadurch gekennzeichnet, dass**
an den Leiterbahnen (3) der Platine (1) insbesondere stiftartige Gegenkontakte (9) angeordnet sind, welche auf der Platine (1) in mehreren quer zur Verlaufsrichtung der Leiterbahnen (3) verlaufenden Reihen mit vorzugsweise jeweils einem Gegenkontakt (9) pro Leiterbahn (3) angeordnet sind und welche jeweils mit einem insbesondere buchsenartigen Kontaktelement eines Steckverbinders (5) der wenigstens zwei Steckverbinder (5) elektrisch verbindbar sind.

5. Kabelsatz nach zumindest einem der vorstehenden Ansprüche, **dadurch gekennzeichnet, dass**
einzelne Kontaktkammern (8) kein Kontaktelement aufweisen.

6. Kabelsatz nach Anspruch 5,
**dadurch gekennzeichnet, dass**
jeweils eine Reihe von insbesondere stiftartigen Gegenkontakten (9a, 9b), welche quer zur Verlaufsrichtung an den Leiterbahnen (3a, 3b) angeordnet ist, einem Steckverbinder (5a) zugeordnet ist und dass die Anordnung der Gegenkontakte (9a, 9b) in der Reihe von Gegenkontakten der Anordnung der Kontaktelemente in der Reihe von Kontaktkammern (7a) des Steckverbinders (5a) entspricht.

7. Kabelsatz nach Anspruch 6,
**dadurch gekennzeichnet, dass**
die Kontaktkammern (8), welche keine Kontaktelemente aufweisen, eine eindeutige Kodierung des Steckverbinders (5a) definieren, welche zur Anbringung des Steckverbinders (5a) an der Platine (1) verwendbar ist, insbesondere zum Auffinden der dem Steckverbinder (5a) zugeordneten Reihe von Gegenkontakten (9a, 9b).

8. Kabelsatz nach zumindest einem der vorstehenden Ansprüche, **dadurch gekennzeichnet, dass**
an jedem der wenigstens zwei Steckverbinder (5) ein Leitungssatz mit einer oder mehreren elektrischen Einzelleitungen angeordnet ist, welche bevorzugt jeweils mit einem Kontaktelement des jeweiligen Steckverbinders (5) elektrisch verbunden sind.

9. Kabelsatz nach zumindest einem der vorstehenden Ansprüche, **dadurch gekennzeichnet, dass**
die Leiterbahnen (3) der Platine (1) in Querrichtung zu ihrer Verlaufsrichtung dieselbe Breite aufweisen und gleichmäßig, insbesondere in einem vorgegebenen Abstand, voneinander beabstandet sind,
dass sich die Leiterbahnen (3) bevorzugt geradlinig in der Verlaufsrichtung erstrecken und bevorzugt in Verlaufsrichtung dieselbe Länge aufweisen, und
dass die Leiterbahnen (3) bevorzugt jeweils aus einer leitenden, insbesondere metallischen Schicht oder aus jeweils einem Metallkamm ausgebildet sind.

10. Kabelsatz nach zumindest einem der vorstehenden Ansprüche, **dadurch gekennzeichnet, dass**
wenigstens eine elektrisch leitende Brücke (11) zwischen zwei benachbarten Leiterbahnen (3) an der Platine (1) befestigt ist, um die zwei benachbarten Leiterbahnen (3) elektrisch zu verbinden.

11. Kabelsatz nach zumindest einem der vorstehenden Ansprüche,
**dadurch gekennzeichnet, dass**
wenigstens eine Leiterbahn (3) der Platine (1) insbesondere mittels eines mechanischen Bearbeitungsprozesses, insbesondere eines Schneid-, Bohr- und/oder Fräsprozesses, in wenigstens zwei Leiterbahnabschnitte unterteilt ist, die elektrisch voneinander isoliert sind.

12. Verfahren zur Herstellung eines Kabelsatzes nach zumindest einem der vorstehenden Ansprüche,
**dadurch gekennzeichnet, dass**
die wenigstens zwei Steckverbinder (5) derart an der Platine (1) befestigt werden, dass die Reihen von Kontaktkammern (7) der wenigstens zwei Steckverbinder (5) quer zur Verlaufsrichtung der Leiterbahnen und insbesondere parallel zueinander angeordnet sind.

13. Verfahren nach Anspruch 12,
**dadurch gekennzeichnet, dass**
jeder Leiterbahn der Platine (1) ein elektrisches Signal zugeordnet wird, und ein Kontaktelement eines Steckverbinders (5), welches zur Zuführung und/oder zum Abgreifen von einem bestimmten der zugeordneten Signale vorgesehen ist, derart in der Reihe von Kontaktkammern (7) des Steckverbinders (5) angeordnet wird, dass die Leiterbahn (3), welcher das bestimmte Signal zugeordnet ist, bei Anbringung des Steckverbinders (5) an der Platine (1) von dem Kontaktelement elektrisch kontaktiert wird.

14. Verfahren nach Anspruch 13,
**dadurch gekennzeichnet, dass**
in Kontaktkammern (8) der Reihe von Kontaktkammern (7) des Steckverbinders (5), welche nicht zur Aufnahme eines Kontaktelements zur Zuführung und/oder zum Abgreifen von einem der zugeordneten Signale vorgesehen sind, keine Kontaktelemente angeordnet werden.

15. Verfahren nach Anspruch 14,
**dadurch gekennzeichnet, dass**
eine Reihe von insbesondere stiftartigen Gegenkontakten (9a, 9b) quer zur Verlaufsrichtung an den Leiterbahnen (3a, 3b) angeordnet und einem Steckverbinder (5a) zugeordnet wird, wobei die Anordnung der Gegenkontakte (9a, 9b) in der Reihe von Gegenkontakten der Anordnung der Kontaktelemente in der Reihe von Kontaktkammern (7a) des zugeordneten Steckverbinders (5a) entspricht.
